(19) Europäisches Patentamt

European Patent Office

Office européen des brevets

(11) **EP 1 553 547 A2**

(12) **EUROPEAN PATENT APPLICATION**

(43) Date of publication:
**13.07.2005 Bulletin 2005/28**

(51) Int Cl.⁷: **G09G 1/16**

(21) Application number: **04030269.7**

(22) Date of filing: **21.12.2004**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **26.12.2003 JP 2003434747**

(71) Applicant: **FANUC LTD**
**Minamitsuru-gun, Yamanashi 401-0597 (JP)**

(72) Inventors:
• **Okita, Tadashi**
  **Fujiyoshida-shi Yamanashi 403-0005 (JP)**
• **Sugiyama, Kazuyuki c/o FANUC**
  **Minamitsuru-gun Yamanashi 401-0511 (JP)**

(74) Representative: **Schmidt, Steffen J., Dipl.-Ing.**
**Wuesthoff & Wuesthoff,**
**Patent- und Rechtsanwälte,**
**Schweigerstrasse 2**
**81541 München (DE)**

(54) **Waveform display apparatus**

(57)     A waveform display apparatus which acquires data from a plurality of channels, and displays information relating to the acquired data in the form of a waveform based on the result of a mathematical operation performed in accordance with a user-entered mathematical expression, wherein at least one mathematical expression is entered and the data output from the plurality of channels are sampled (S01), the entered mathematical expression is analyzed (S02), the at least one mathematical expression is applied to the digital data of the plurality of channels based on the analysis (S03), and the information relating to the data is displayed in the form of a waveform on a display unit based on the result of the mathematical operation (S04). In this way, the user can have the result of the mathematical operation displayed in the desired manner, without having to add a new data processing method each time a necessary operation is added.

FIG. 3

EP 1 553 547 A2

**Description**

BACKGROUND OF THE INVENTION

1. Field of the Invention

The present invention relates to a waveform display apparatus which collects digital data from a plurality of channels, and displays information relating to the collected digital data of each channel in the form of a time-series waveform or performs a mathematical operation using the data between the plurality of channels and displays information relating to the collected digital data in the form of a waveform by using the result of the mathematical operation.

2. Description of the Related Art

Various kinds of control apparatuses, including numerical control apparatuses, are often constructed so as to be able to monitor and observe the condition of a control target by displaying the condition based on the various kinds of data detected from the control target. Generally, in a waveform display apparatus which acquires digital data from a plurality of channels on a control target and displays information relating to the digital data in the form of a waveform, data such as shown below are stored in its internal array.

$$\text{Time data } (n) = t \times n$$

$$\text{First channel data } (n) = CH1(n)$$

$$\text{Second channel data } (n) = CH2(n)$$

where t is sampling time, and n is data index.
Usually, when displaying the information relating to these pieces of data in the form of a time-series graph, the data are set as

$$X(n) = \text{Time data } (n)$$

$$Y1(n) = \text{First channel data } (n)$$

$$Y2(n) = \text{Second channel data } (n)$$

and a waveform is displayed by plotting the combination of X and Y1 data or X and Y2 data on an XY graph.
Further, when the first channel data and the second channel data are data both having positional dimensions, then when the data are set as

$$X(n) = \text{First channel data } (n)$$

$$Y(n) = \text{Second channel data } (n)$$

the locus of two-dimensional positions can be displayed by using the combination of X and Y data and plotting them on an XY graph.
It is also practiced to define a prescribed mathematical operation appropriate to the purpose and display information representing the result of the operation. For example, consider the case where combined speed is obtained from two pieces of data, the position data measured on the first channel and the position data measured on the second channel, and the combined speed is displayed in the form of a time series. In this case, the operation

$$X(n) = \text{time data } (n)$$

$$Y(n) = \sqrt{\{[d(\text{First channel data 1}(n))/dt]^2}$$

$$+ [d(\text{Second channel data 2}(n))/dt]^2\}$$

is defined, and a waveform representing the combined speed Y(n) is displayed by using the combination of X and Y data and plotting them on an XY graph.

[DISCLOSURE OF THE INVENTION]

[Problem to be Solved by the Invention)

When generating a waveform display by using a data train created by performing a mathematical operation between the data acquired from a plurality of channels, in the prior art it has been possible to generate the waveform in cases where a prescribed operation (for example, addition) can handle the situation, but it has not been possible to generate the waveform in cases where an operation that cannot be handled in that category becomes necessary. Accordingly, in the prior art, as a new data processing method (software algorithm) has had to be added to address the situation each time the necessary operation is added, there has been no freedom in selecting mathematical expressions. More specifically, the freedom in selecting mathematical expressions has been greatly limited.

SUMMARY OF THE INVENTION

In view of this, it is an object of the present invention to provide a waveform display apparatus which acquires data from a plurality of channels, and displays information relating to the acquired data in the form of a waveform on a display unit by just requiring the user to enter a desired mathematical expression, eliminating the need to add a new data processing method each time the necessary operation is added.

A waveform display apparatus according to the present invention that solves the above problem performs a mathematical operation on signals output from a plurality of channels, and displays information relating to the signals in the form of a waveform based on data obtained from the mathematical operation, wherein the apparatus comprises: sampling data storing means for sampling the signals output from the plurality of channels, and for storing the sampled signals as digital data; mathematical expression entering means for entering at least one mathematical expression; mathematical operation means for reading out the digital data of at least one of the plurality of channels from the sampling data storing means, and for applying the at least one mathematical expression to the readout digital data; and a display unit for displaying the information relating to the signals in the form of a waveform based on data representing a mathematical operation result obtained by applying in the mathematical operation means the at least one mathematical expression to the digital data of the at least one channel.

In the waveform display apparatus according to the present invention, the waveform is displayed by taking a first axis as a time axis or a position axis and a second axis as an axis representing the information relating to the signals based on the mathematical operation result.

Alternatively, in the waveform display apparatus according to the present invention, the waveform representing the information relating to the signals is displayed by plotting, along a first axis, data representing a first mathematical operation result obtained by applying one or more of mathematical expressions selected from among the at least one mathematical operation to the digital data of the at least one channel, while plotting along a second axis, data representing a second mathematical operation result obtained by applying the other one or more of mathematical expressions selected from among the at least one mathematical operation to the digital data of the at least one channel.

In the waveform display apparatus according to the present invention, the mathematical expression consists of one operation or a combination of at least two operations selected from among addition, subtraction, multiplication, division, trigonometric functions, raising to a power, square rooting, exponential functions, and logarithmic functions.

In the waveform display apparatus according to the present invention, the display unit is a display unit for a numerical control apparatus that controls a machine tool.

In the waveform display apparatus according to the present invention, the display unit is a display unit for a personal computer.

According to the waveform display apparatus of the present invention, as the information relating to the data acquired from the plurality of channels can be displayed in the form of a waveform on the display unit based on the result of the mathematical operation performed on the acquired data by using a user-entered mathematical equation, the freedom in selecting mathematical expressions increases.

BRIEF DESCRIPTION OF THE DRAWINGS

Figure 1 is a block diagram showing the essential portions of a numerical control apparatus according to one embodiment to which the waveform display apparatus of the present invention is applied.

Figure 2 is a diagram showing how work is machined in a two-dimensional shape by operating a rotating axis and a linear axis in synchronized fashion.

Figure 3 is a flowchart illustrating the waveform display processing performed by a CPU in the numerical control apparatus of the embodiment.

Figure 4 is a graph showing waveforms obtained from data sampled by taking the X axis as a time axis and the Y axis as an axis representing the position of the linear axis of a cutter and the angle position of the rotating axis of the work.

Figure 5 is a graph showing waveforms obtained from mathematical operation result data by taking the X axis as a time axis and the Y axis as an axis representing (Position of the linear axis of the cutter) $\times$ cos(Angle of the rotating axis) and (Position of the linear axis of the cutter) $\times$ sin(Angle of the rotating axis).

Figure 6 is a graph showing waveforms obtained from mathematical operation result data by taking the X axis as an axis representing (Position of the linear axis of the cutter) $\times$ cos(Angle of the rotating axis) and the Y axis as an axis representing (Position of the linear axis of the cutter $\times$ sin (Angle of the rotating axis).

DESCRIPTION OF THE PREFERRED EMBODIMENTS

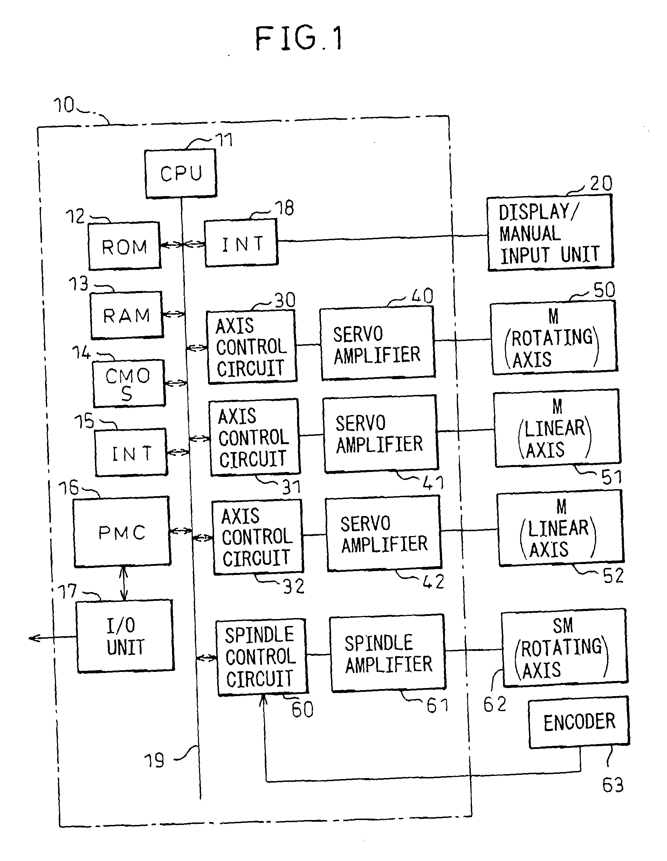

Figure 1 is a block diagram showing the essential portions of a numerical control apparatus according to one embodiment to which the waveform display apparatus of the present invention is applied. A CPU 11 is a processor which controls the entire operation of the numerical control apparatus 10. The CPU 11 reads a system program out of a ROM 12 via a bus 19, and controls the entire operation of the numerical control apparatus 10 in accordance with the system program. A RAM 13 temporarily stores calculation data, display data, and various kinds of data. The various kinds of data refer to the data that the operator entered via a display unit/manual input unit 20 which comprises a display unit, such as a CRT or liquid crystal display, and a manual input means, such as a keyboard. In the present embodiment, the display unit/manual input unit 20 also functions as a mathematical expression entering means according to the present invention, and the user enters a desired mathematical expression (at least one mathematical expression) from the display unit/manual input unit 20.

A CMOS memory 14 is powered by a battery not shown, and is thus constructed as a nonvolatile memory which preserves its stored contents when power is turned off to the numerical control apparatus 10. Programs such as a machining program loaded via an interface 15, a machining program entered via the display unit/manual input unit 20, etc. are stored in the CMOS memory 14. Further, in the present embodiment, at least one mathematical expression entered via the display unit/manual input unit 20 is stored in the CMOS memory 14. The ROM 12 permanently stores various system programs for implementing edit functions necessary to create and edit machining programs, and for performing the waveform display processing necessary to display a waveform in a waveform display area on the display screen of the display unit/manual input unit 20 which, as will be described later, displays information relating to the data of at least one channel based on the data representing the mathematical operation result obtained by applying the at least one mathematical expression to the digital data of the at least one channel.

The interface 15 enables the numerical control apparatus 10 to connect to external devices. A PMC (Programmable Machine Controller) 16 is a sequence program built into the numerical control apparatus 10, and performs control by transferring signals via an I/O unit 17 to and from an auxiliary device (for example, an actuator such as a tool changing robot hand) of a machine tool to be controlled. Further, the I/O unit 17 receives signals from various switches mounted on the operation panel incorporated in the main body of the machine tool being controlled by the numerical control apparatus, and passes the signals to the CPU 11 after applying necessary signal processing.

Axis control circuits 30 to 32, in response to axis moving amounts commanded by the CPU 11, control the respective axes of the machine (control target) by driving servo motors 50 to 52 for the respective axes via servo amplifiers 40 to 42. The servo motors 50 to 52 for the respective axes are each equipped with a built-in position/speed detector, and position/speed feedback control is performed by supplying the position/speed feedback signals from the position/speed detectors to the respective axis control circuits 30 to 32. In Figure 1, the position/speed feedback configuration is not shown. Each of the axis control circuits 30 to 32 is provided with a present position register for storing the present position of a corresponding one of the servo motors 50 to 52 based on the position feedback signal, as in the prior art, but the present position register is not shown in Figure 1. Further, in the example shown in Figure 1, the servo motor 50 which drives a rotating feed axis is connected to a first channel (on which the axis control circuit 30 and the servo amplifier 40 are connected), the servo motor 51 which drives a first linear feed axis (X axis) is connected to a second channel (on which the axis control circuit 31 and the servo amplifier 41 are connected), and the servo motor 52 which drives a second linear feed axis (Y axis) is connected to a third channel (on which the axis control circuit 32 and the servo amplifier 42 are connected).

A spindle control circuit 60 receives a spindle rotation command, and outputs a spindle speed signal to a spindle amplifier 61. The spindle amplifier 61, in response to the spindle speed signal, causes a spindle motor 62 to rotate at the commanded rotational speed. A position coder 63 is used to control the speed of the spindle motor 62 by supplying feedback pulses to the spindle control circuit 60 in synchronism with the rotation of the spindle motor 62.

A description will be given below of how a waveform display is produced in the numerical control apparatus 10 configured as described above. First, the user enters from the display unit/manual input unit 20 a mathematical expression by specifying a data train X(n) corresponding to the X axis (horizontal axis) and a data train Y(n) corresponding to the Y axis (vertical axis) in the waveform display area on the display screen of the display unit/manual input unit 20. Here, the mathematical expression can be entered by selecting one operation or a combination of at least two operations from among addition, subtraction, multiplication, division, trigonometric functions, raising to a power, square rooting, exponential functions, and logarithmic functions.

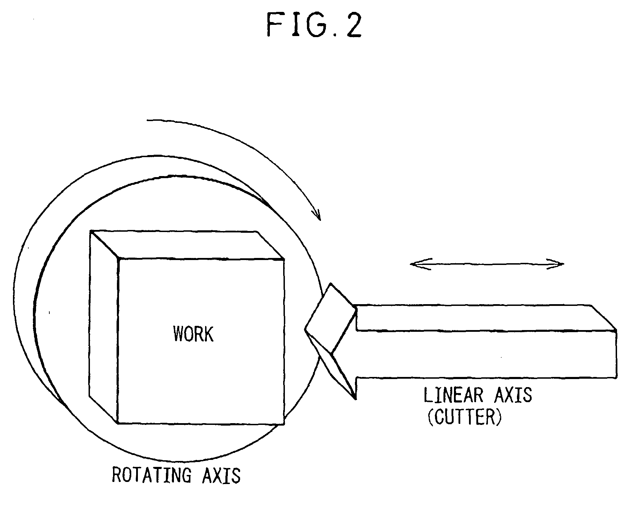

In one specific example, as shown in Figure 2, the rotating axis (first channel) of the machine tool controlled by the numerical control apparatus 10 is driven by the servo motor 50 to rotate the work, and the first linear feed axis (second channel) is driven by the servo motor 51 to move the cutter in a straight line, cutting a two-dimensional shape by operating the rotating axis and the linear axis in synchronized fashion. In this case, when the motion of the cutting blade end is observed, the angle data of the rotating axis rotating with the work clamped thereon is taken as the position data of the first channel (the value of the present position register that stores the present position of the servo motor 50), and the position data of the linear axis in the linear motion direction of the cutter cutting the work (the value of the present position register that stores the present position of the servo motor 51) is taken as the position data of the second channel; then, these digital data are sampled and stored as digital data.

Then, the mathematical expressions that yield the data corresponding to the X axis (horizontal axis) and Y axis (vertical axis) for producing a waveform display, that is,

X = (Position data of the second channel) × cos(Position (angle) data of the first channel)

Y = (Position data of the second channel) × sin(Position (angle) data of the first channel)

are entered from the display unit/manual input unit 20.

Data indicating the mathematical operation results obtained by applying the above mathematical expressions to the data acquired from the first and second channels for each sampling point, i.e., the set of X (horizontal axis) and Y (vertical axis) data trains, is plotted on an XY graph to produce a waveform display; in this way, the waveform representing the shape of the work can be displayed in two dimensions.

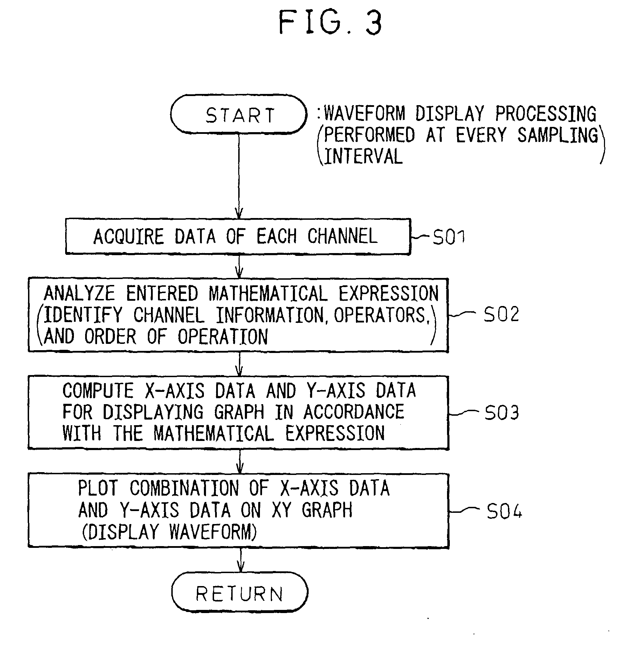

figure 3 is a flowchart illustrating the waveform display processing performed by the CPU 11 in the numerical control apparatus 10. when a waveform display command is input, the CPU 11 performs the processing of Figure 3 at each prescribed sampling interval. First, data of each channel is acquired (step S01). That is, the value of the present position register for each axis (servo motor 50, 51, 52) is read out and stored in association with data index n (whose initial value is "1"). Next, the CPU 11 analyzes the at least one mathematical expression entered and stored in the CMOS memory 14 (step S02). That is, the mathematical expression given in the form a character string is read out for each of the X axis (horizontal axis) and Y axis (vertical axis) of the display screen, and the channels to be operated on, the kinds of the operators, and the order of operation are identified.

Consider, for example, the case where the following mathematical expression is given.

$$X = (CH1+CH2)/2$$

In this case, the mathematical expression is analyzed as described below. That is, channel 1 and channel 2 are used as the channels to be operated on, addition and division are used as the operators, and channel 1 and channel 2 are added together, followed by the division by a constant "2". The final result of the operation is stored in a data array called X. The actual operation is performed in accordance with the result of the mathematical expression analysis. In this analysis, the contents of the operations in any mathematical expressions using addition, subtraction, multiplication, division, trigonometric function, raising to power, square rooting, exponential function, and logarithmic function, can be analyzed.

Next, the CPU 11 computes X-axis data and Y-axis data for displaying a graph in accordance with the mathematical expression (step S03). Then, by plotting the combination of the thus computed X-axis data and Y-axis data on an XY graph, information relating to the data acquired from each channel is displayed in the form of a waveform on the display screen of the display unit/manual input unit 20 (step S04). One cycle of the waveform display processing is thus completed.

Here, provisions may be made to automatically start the waveform display processing upon initiation of cutting work. In that case, an execution flag is set, for example, when the cutting work is initiated, and reset when the cutting work is completed; when the execution flag is set, the above process from steps S01 to S04 is performed at each sampling interval.

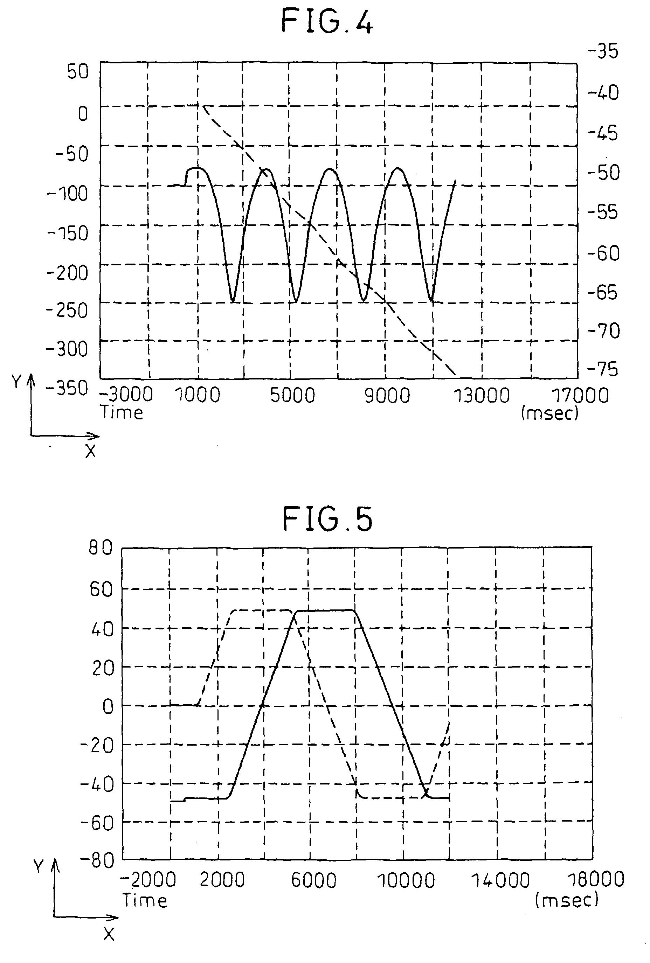

When producing a waveform display while cutting a two-dimensional shape by the machine tool by operating the rotating axis and the linear axis in synchronized fashion, in the example shown in Figure 4 the X axis is taken as a time axis, i.e., X = t(n), and the Y axis is taken to represent the position of the linear axis of the cutter and the angle position of the rotating axis, i.e., Y = second channel and Y = first channel; in this case, the result of sampling the position data of the linear axis as the second channel describes a substantially sinusoidal waveform as shown by a solid line in Figure 4. On the other hand, the result of sampling the angle data of the rotating axis as the first channel describes a substantially linear waveform as shown by a dashed line in Figure 4. As for the numeric values alongside the Y axis, the values at the left in Figure 4 indicate the angle position (deg) of the rotating axis, and the values at the right in Figure 4 represent the position of the linear axis. From the display screen such as shown in Figure 4, it can be seen that the linear axis is moving in reciprocating fashion, while the rotating axis is rotating constantly in one direction.

Figure 5 shows the waveforms displayed in accordance with the data representing the mathematical operation results obtained by setting the X axis as the time axis and by computing Y = (Position data of the second channel) × cos(Position (angle) data of the first channel) = Position of the linear axis × cos(Angle of the rotating axis) (shown by a solid line in Figure 5) and Y = (Position data of the second channel) × sin(Position (angle) data of the first channel) = Position of the linear axis × sin(Angle of the rotating axis) (shown by a dashed line in Figure 5); position data on virtual X axis and virtual Y axis created by combining the rotating axis and linear axis can be read from Figure 5.

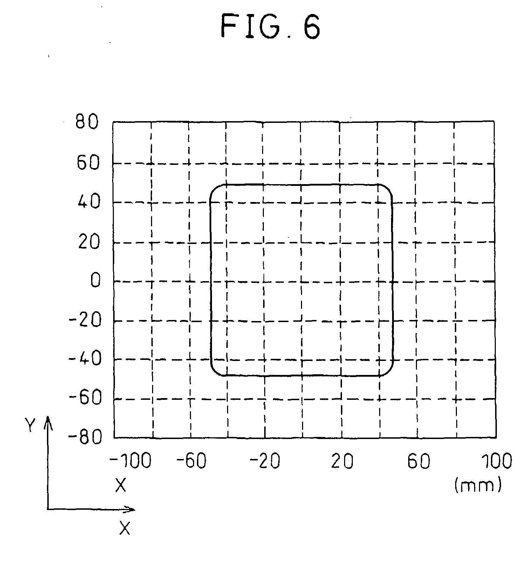

In Figure 6, the mathematical expressions that yield the data corresponding to the X axis and the Y axis are entered as X = (Position data of the second channel) × cos(Position (angle) data of the first channel) = Position of the linear axis x cos(Angle of the rotating axis) and Y = (Position data of the second channel) × sin(Position (angle) data of the first channel) = Position of the linear axis x sin(Angle of the rotating axis), and the results of the mathematical operations are displayed. In Figure 6, the waveform representing the two-dimensional shape of the work cut by operating the rotating axis and the linear axis in synchronized fashion is shown as the information relating to the data acquired from the respective channels in step S01.

As, based on the entered mathematical expressions, the results of the mathematical operations are displayed on the screen of the display unit as described above, the information relating to the data acquired from each channel, for example, the waveform representing the two-dimensional shape, can be displayed in graph form by reflecting the result obtained by applying the desired mathematical expression that the operator entered.

In the above embodiment, the waveform display is produced on the display screen of the display unit/manual input unit 20 of the numerical control apparatus 10, but alternatively, a personal computer may be connected to the numerical control apparatus 10, and the waveform display may be produced on the display screen of the personal computer.

Further, the above embodiment has been described by taking an example in which the machine tool has three feed axes (three channels) and data of two of the three axes are used, but it will be appreciated that according to the invention, when there are many channels to be controlled, the user can have the desired data displayed in graph form in the desired manner by entering desired mathematical expressions, selecting desired channels, performing mathematical operations using the data of the selected channels, and having the results displayed in graph form.

## Claims

1.    A waveform display apparatus which performs a mathematical operation on signals output from a plurality of channels, and displays information relating to said signals in the form of a waveform based on data obtained from said mathematical operation, said apparatus comprising:

    sampling data storing means for sampling the signals output from said plurality of channels, and for storing said sampled signals as digital data;
    mathematical expression entering means for entering at least one mathematical expression;
    mathematical operation means for reading out the digital data of at least one of said plurality of channels from said sampling data storing means, and for applying said at least one mathematical expression to said readout digital data; and
    a display unit for displaying the information relating to said signals in the form of a waveform based on data representing a mathematical operation result obtained by applying in said mathematical operation means said at least one mathematical expression to the digital data of said at least one channel.

2.    A waveform display apparatus as claimed in claim 1, wherein said waveform is displayed by taking a first axis as a time axis or a position axis and a second axis as an axis representing the information relating to said signals based on said mathematical operation result.

3.    A waveform display apparatus as claimed in claim 1, wherein said waveform representing the information relating to said signals is displayed by plotting, along a first axis, data representing a first mathematical operation result obtained by applying one or more of mathematical expressions selected from among said at least one mathematical operation to the digital data of said at least one channel, while plotting along a second axis, data representing a second mathematical operation result obtained by applying the other one or more of mathematical expressions selected from among said at least one mathematical operation to the digital data of said at least one channel.

4.    A waveform display apparatus as claimed in any one of claims 1 to 3, wherein said mathematical expression consists of one operation or a combination of at least two operations selected from among addition, subtraction, multiplication, division, trigonometric functions, raising to a power, square rooting, exponential functions, and logarithmic functions.

5.    A waveform display apparatus as claimed in any one of claims 1 to 4, wherein said display unit is a display unit for a numerical control apparatus that controls a machine tool.

6.    A waveform display apparatus as claimed in any one of claims 1 to 4, wherein said display unit is a display unit for a personal computer.

# FIG.1

10

CPU 11

ROM 12 ⟷ INT 18 — DISPLAY/ MANUAL INPUT UNIT 20

RAM 13

AXIS CONTROL CIRCUIT 30 — SERVO AMPLIFIER 40 — M (ROTATING AXIS) 50

CMOS 14

INT 15

AXIS CONTROL CIRCUIT 31 — SERVO AMPLIFIER 41 — M (LINEAR AXIS) 51

PMC 16

AXIS CONTROL CIRCUIT 32 — SERVO AMPLIFIER 42 — M (LINEAR AXIS) 52

I/O UNIT 17

SPINDLE CONTROL CIRCUIT 60 — SPINDLE AMPLIFIER 61 — SM (ROTATING AXIS) 62

ENCODER 63

19

# FIG.2

WORK

ROTATING AXIS

LINEAR AXIS
(CUTTER)

# FIG. 3

```
        ┌─────────────┐   : WAVEFORM DISPLAY PROCESSING
        │    START    │   ⎛ PERFORMED AT EVERY SAMPLING ⎞
        └─────────────┘   ⎝ INTERVAL                    ⎠
               │
               ▼
  ┌────────────────────────────────┐
  │  ACQUIRE DATA OF EACH CHANNEL   │─── S01
  └────────────────────────────────┘
               │
               ▼
  ┌────────────────────────────────────────────┐
  │ ANALYZE ENTERED MATHEMATICAL EXPRESSION     │
  │ ⎛ IDENTIFY CHANNEL INFORMATION, OPERATORS, ⎞│─── S02
  │ ⎝ AND ORDER OF OPERATION                   ⎠│
  └────────────────────────────────────────────┘
               │
               ▼
  ┌────────────────────────────────────────────┐
  │ COMPUTE X-AXIS DATA AND Y-AXIS DATA         │
  │ FOR DISPLAYING GRAPH IN ACCORDANCE          │─── S03
  │ WITH THE MATHEMATICAL EXPRESSION            │
  └────────────────────────────────────────────┘
               │
               ▼
  ┌────────────────────────────────────────────┐
  │ PLOT COMBINATION OF X-AXIS DATA             │
  │ AND Y-AXIS DATA ON XY GRAPH                 │─── S04
  │ (DISPLAY WAVEFORM)                          │
  └────────────────────────────────────────────┘
               │
               ▼
        ┌─────────────┐
        │   RETURN    │
        └─────────────┘
```

# FIG.4

# FIG.5

# FIG. 6